(19) Europäisches Patentamt
European Patent Office
Office européen des brevets

(11) EP 0 723 677 B1

(12) **EUROPEAN PATENT SPECIFICATION**

(45) Date of publication and mention of the grant of the patent:
**22.03.2000 Bulletin 2000/12**

(21) Application number: **94930735.9**

(22) Date of filing: **12.10.1994**

(51) Int. Cl.$^7$: **G03F 7/09**

(86) International application number:
**PCT/US94/11570**

(87) International publication number:
**WO 95/10798 (20.04.1995 Gazette 1995/17)**

(54) **TOP ANTI-REFLECTIVE COATING FILMS**

REFLEXIONSVERMINDERNDE OBERFLÄCHENBESCHICHTUNGEN

PELLICULES PROTECTRICE ANTIREFLET

(84) Designated Contracting States:
**DE FR GB IT**

(30) Priority: **12.10.1993 US 135036**

(43) Date of publication of application:
**31.07.1996 Bulletin 1996/31**

(73) Proprietor:
**Clariant Finance (BVI) Limited**
**Road Town, Tortola (VG)**

(72) Inventors:
- **JAIN, Sangya**
  **Bridgewater, NJ 08807 (US)**
- **FUNK, Rudiger**
  **D-65207 Wiesbaden (DE)**

(74) Representative:
**Hütter, Klaus, Dr. et al**
**Clariant GmbH**
**Patente, Marken, Lizenzen**
**Am Unisys-Park 1**
**65843 Sulzbach (DE)**

(56) References cited:
**EP-A- 0 522 990**
**EP-A- 0 583 918**
**US-A- 5 139 879**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Xerox (UK) Business Services
2.16.7/3.6

## Description

### Field of the Invention

The present invention relates to improved compositions for enhancing the performance of aqueous developable photoresists by substantially eliminating pattern distortion caused by reflections over non-planar features on the substrate being patterned. The invention is directed to improved water soluble, and-reflective top coating compositions which are easy to apply, provide better process control of image formation, and are aqueous soluble and, therefore, are easily removed using existing lithographic processing, which minimize environmental hazards and do not significantly add to lithographic process costs.

### Background of the Invention

The use of anti-reflection coatings for optical devices, such as lenses in photographic and other equipment is well known in the prior art. These coatings take advantage of the relationship described in the Fresnel formulae. It is well established that the refractive index of an overlying material should be about the square root of the refractive index of the underlying material and that the thickness of the coating or layer should be an odd integer multiple of one-quarter of the wavelength of the incident radiation, the so-called "quarter-wavelength thickness".

In U.S. Patent No. 4,759,990 to Y-T. Yen, the and-reflective coating concept is extended for use over optical membrane elements (pellicles) which are used in the manufacture of semiconductor wafers. The pellicle is typically made from a nitrocellulose film which is stretched over a pellicle holder. The use of an aromatic vinyl polymer such as polyvinyl naphthalene, polymethylstyrene or polystyrene as a first coating layer, followed by a fluorocarbon layer, such as 3M's FC-721 or FC-77. is disclosed. Pellicles may be used a number of times before they suffer either mechanical break down or cover contamination. Such pellicles are either cleaned, reworked or replaced.

Tanaka et at, J. Electrochem. Soc., 137, 3900 (1990) (Tanaka I) discloses a process for directly applying an antireflective coating on top of a photoresist. This technique attempts to overcome problems which have been encountered due to reflectivity when increasing the degree of pattern densification, in trying to achieve ULSI having sub-0.5 μm geometries.

Light interference leads to linewidth variations and degraded detection of through-the-lens (TTL) alignment marks. Tanaka I discloses the formation of an anti-reflective film on a photoresist surface, which is sufficient to suppress the multiple interference effects due to repeated reflection of incident light in the resist film. The anti-reflective film is clear, has its thickness and refractive index optimized and is used in a process which entails the steps of coating and baking a photoresist in the conventional way, spin-coating a film of the anti-reflective coating on the photoresist, imaging the composite structure, removing the anti-reflective film, and developing the photoresist. This process adds the steps of spin-coating and removal of the anti-reflective film.

Using the Fresnel formulae, Tanaka I determined that the refractive index of the anti-reflective material should be about the square root of the refractive index of the imaging photoresist used. Tanaka I used a photoresist having a refractive index of 1.64 and, thus, the ideal anti-reflective coating refractive index was 1.28. The Tanaka I material falls into two categories: (1) those which suppress reflection effects and which require organic solvent strip; and (2) those which are aqueous strippable, but which provide little process benefit. (Refractive index ≥1.48.)

Tanaka et al., J. App. Phys., 67, 2617 (1990) (Tanaka II) discloses the use of perfluoroalkyl polyether and di-propoxy-bis(acetyl-acetonate)titanium as anti-reflective materials for single and bilayer films, to control the interface reflectivities, as well as methods to measure such reflectivities. Tanaka II entails the use of baking steps to fix the one and two layer coatings disclosed. He is silent on the use of post exposure and develop methods to remove the anti-reflective layer(s).

Tanaka et al, Chem. Abs. 107:87208y (1987) (Tanaka III) is directed to the subject matter of JP 62 62,520. It discloses a process for coating a photoresist with an anti-reflective coating which may comprise perfluoroalkyl- polyether, perfluoroalkylamine, or a perfluoroalkyl- polyether-perfluoroalkylamine mixed film. The reflection-preventive film is removed after pattern wise exposure using a Freon®, a chloro-fluorocarbon ("CFC") solvent.

The Tanaka materials having the desired refractive indices are expensive to use. There is the required additional process step to remove the anti-reflective material. In addition, the removal step requires an organic solvent which is expensive to make or purchase and requires time and expense to safely handle and dispose of. Finally, the nature of Tanaka's solvents, as CFC's, requires extreme care to protect against environmental damage. The waste management aspects of the Tanaka reflection-preventative materials weigh heavily against their use.

U.S. Patent 4,701,390 to Grunwald et al., discloses a process for thermally stabilizing a photoresist image layer formed on a substrate wherein the image layer, prior to being sujected to a post-development bake, is coated with a protective material which bonds to the photoresist, but is readily rinsed from the exposed substrate after post bake and does not interfere with the desired operation of any of the subsequent steps of pattern generation, including final removal of the photoresist image. The protective (thermally stabilizing) material may be a compound or a mixture of two or more compounds selected from chromotropic acid, perfluorocarbon carboxylic acids, perfluorocarbon sulfonic acids, perfluorocarbon phosphoric acids (and alkali metal, ammonium and amine salts of such acids), ethoxylated perfluorocarbon alcohols and quaternary ammonium salts of N-perfluoro-N',N"-dialkylamines.

EP-A2-0 583 918 discloses a reflection preventing film and process for forming resist pattern using the same, comprising a copolymer with recurring acrylic acid and acrylic acid fluoroalkyl ester units, the latter being different from the present invention.

Summary of the Invention

In order to overcome the deficiencies of the materials and top anti-reflective processes of the prior art, the present invention provides anti-reflective coating compositions having a refractive index of from greater than about 1.20 to about 1.40, preferably from about 1.29 to about 1.40, which is capable of being applied in a single quarter wavelength thickness and are removable with water or with the developer for the underlying photoresist.

The present invention relates to a new water soluble anti-reflective top coat material for photoresists. The novel material comprises a new group of fluorinated polymers and, preferably, an additive to enhance to water solubility of such polymers. Preferably the additive is a surfactant, most preferably it is a fluorinated surfactant. The top coat is spin coaxed onto the photoresist and imaging is done in the normal manner. The unique materials of the top coat are water soluble, so when the top coat solution is spin coated onto the photoresist, no intermixing betwen the two layers occurs. Additionally, a water based top coat is environmentally safer than organic based solutions. In cases where the fluorinated polymers are themselves soluble in water or are soluble in water upon heating, no additive is required.

The family of polymers which comprises the anti-reflective coating of the present invention have a refractive index of from greater than about 1.20 to about 1.40, may be applied in a single quarter wavelength thickness, are removable with water or with the developer for the photoresist and are copolymers containing the following units:

a)

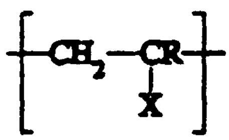

where X is $CO_2L$, $SO_3L$, OH, $CO(OC_2H_4)_xOH$, $CONHC(CH_3)_2CH_2SO_3L$, $PO_3L_2$ or $CONH_2$ where L = H, a Group I or Group II cation or $NH_4^+$ and x = 0-10

b) an acrylic acid perfluoroalkyl-ester with 8 - 12 C-atoms in the ester alcohol group or

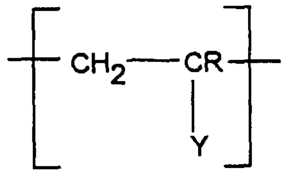

where

Y is fluorine or a fluorine containing aliphatic organic substituent selected from the group consisting of $-COO-(CH_2)_2(CF_2)_{x1}-CF_3$, where x1 is 7 to 11; $-SO_2O(CH_2)_x(CF_2)_n-CF_3$, $-SO_2(OC_2H_4)_xO(CH_2)_x(CF_2)_nCF_3$, where n is 0 - 14 and x is 0 - 10; and

R is H, halogen, $CF_3$, $(C_1-C_8)$alkyl or CN.

The present invention also relates to a process for making an anti-reflective coating composition for a photoresist, the coating having a refractive index of from greater than about 1.20 to about 1.40, and being capable of being applied in a single quarter wavelenth thickness and is removable with water or with a developer for the underlying photoresist; the process composition providing a copolymer containing the following units:

a)

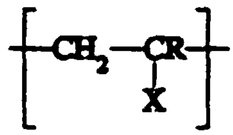

where X is $CO_2L$, $SO_3L$, OH, $CO(OC_2H_4)_xOH$, $CONHC(CH_3)_2CH_2SO_3L$, $PO_3L_2$ or $CONH_2$ where L = H, a Group I or Group II cation or $NH_4^+$ and x = 0-10

b) an acrylic acid perfluoroalkyl-ester with 8 - 12 C-atoms in the ester alcohol group or

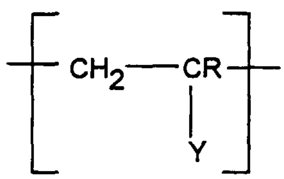

where

Y is fluorine or a fluorine containing aliphatic

organic substituent selected from the group consisting of $-COO-(CH_2)_2(CF_2)_{x1}-CF_3$, where x1 is 7 to 11; $-SO_2O(CH_2)_x(CF_2)_n-CF_3$, $-SO_2(OC_2H_4)_xO(CH_2)_x(CF_2)_nCF_3$, where n is 0 - 14 and x is 0 - 10; and

R is H, halogen, $CF_3$, $(C_1-C_8)$alkyl or CN.

Perferably, the polymer is a copolymer of $CH_2=CH-CO-O-(CH_2)_2(CF_2)x-CF_3$ and acrylic acid, where x = 7 to 11.

The additives are those compounds which aid in solubilizing the polymer if the polymer is itself insoluble, or not sufficiently soluble, in water. These compounds are typically surfactants, emulsifiers or dispersants. Preferably, surfactants that are water soluble are used. Additives that may be utilized include ammonium pentadecafluoroctanoate, the amine salt of perfluoroctanoic acid, ammonium perfluoroctanosulfonate and ammonium lauryl sulfate.

Example 1

To a 0.5 l flask with a reflux condensor and a stirrer was added the following chemicals:

| | |
|---|---|
| 185 ml | cyclohexane |
| 16 g | Fluowet EA 812 acrylate (acrylic acid perfluoralkyl-ester with 8-12 C-atoms in the ester alcohol group), |
| 4 g | acrylic acid, and |
| 0.4 g | dilauroylperoxide. |

The reaction mixture was then heated to reflux (80°C). After 20-30 minutes, the polymerization was determined by a white powder, that was precipitating. After an additional 3 hours stirring under reflux, the polymerization was completed. The polymer (fine white powder) was isolated by filtration and was dried in a vacuum at 80°C.

Example 2

A resin was synthesized according to the procedure of Example 1 by polymerizing acrylic acid and $CH_2=CHCO-O-(CH_2)_2-(CF_2)_xCF_3$ in the ratio 32/68, where x was between 7 and 11. A formulation was made as follows:

| | |
|---|---|
| Resin - | 0.31 g |
| Additive - | 0.68g |
| Water- | 18.0 g |

The additive used was the tetramethylammonium salt of pentadecafluorooctanoic acid.

Example 3

A resin was synthesized according to the procedure of Example 1 by polymerizing acrylic acid and $CH_2=CHCO-O-(CH_2)_2-(CF_2)_xCF_3$ in the ratio 32/68, where x was between 7 and 11. A formulation was made as follows:

| | |
|---|---|
| Resin - | 0.33 g |
| Additive - | 4.0 g (25% active) |
| Water - | 16.0 g |

The additive used was the amine salt of perfluorooctanosulfonic acid.

Example 4

A resin was synthesized according to the procedure of Example 1 by polymerizing acrylic acid and $CH_2=CHCO-O-(CH_2)_2-(CF_2)_xCF_3$ in the ratio 39/61, where x was between 7 and 11. A formulation was made as follows:

| | |
|---|---|
| Resin - | 0.32 g |
| Additive - | 4.0 g (25% active) |
| Water - | 16.0 g |

The additive used was the amine salt of perfluoroctanosulfonic acid.

Example 5

A resin was synthesized according to the procedure of Example 1 by polymerizing acrylic acid and $CH_2=CHCO-O-(CH_2)_2-(CF_2)_xCF_3$ in the ratio 39/61, where x was between 7 and 11. A formulation was made as follows:

| | |
|---|---|
| Resin - | 1.0 g |
| Additive - | 0.65 g |
| Water - | 15.0 g |

The additive used was ammonium perfluoroctanote.

Example 6

A resin was synthesized according to the procedure of Example 1 by polymerizing acrylic acid and $CH_2=CHCO-O-(CH_2)_2-(CF_2)_xCF_3$ in the ratio 39/61, where x was between 7 and 11. A formulation was made as follows:

| | |
|---|---|
| Resin - | 0.33 g |
| Additive - | 2.3 g (25% active) |
| Water - | 17.4 g |

The additive used was the amine salt of perfluoroctanosulfonic acid.

Example 7

A resin was made according to the procedure of Example 1 by polymerizing acrylic acid and

$CH_2$=CHCO-O-$(CH_2)_2$-$(CF_2)_x CF_3$ in the ratio 39/61, where x was between 7 and 11. A formulation was made as follows:

Resin - 0.3 g
Additive - 0.68 g
Water - 18.0 g

The additive used was the tetramethyl ammonium salt of perfluoroctanoic acid.

Example 8

A resin was made according to the procedure of Example 1 by polymerizing acrylic acid and $CH_2$=CHCO-O-$(CH_2)_2$-$(CF_2)_x CF_3$ in the ratio 20/80, where x was between 7 and 11. A formulation was made as follows:

Resin - 0.2 g
Additive - 0.68 g
Water - 18.0 g

The additive used was the tetramethyl ammonium salt of perfluoroctanoic acid.

Example 9

A resin was synthesized according to the procedure of Example 1 by polymerizing of acrylic acid and $CH_2$=CHCO-O-$(CH_2)_2$-$(CF_2)_x CF_3$ in the ratio 20/80, where x was between 7 and 11. A formulation was made as follows:

Resin - 0.32 g
Additive - 2.3 g (25% active)
Water - 17.4 g

The additive used was an amine salt of perfluoroctanosulfonic acid.

| Example Number or Sample | Refractive Index |
|---|---|
| 2 | 1.37 |
| 3 | 1.39 |
| 4 | 1.395 |
| 5 | 1.40 |
| 6 | 1.40 |
| 7 | 1.38 |
| 8 | 1.35 |
| 9 | 1.38 |

(continued)

| Example Number or Sample | Refractive Index |
|---|---|
| Polyacrylic Acid | 1.51 |

Comparative Example 10

Several silicon substrates were spin coated with film thicknesses ranging from 0.9-1.3µm using AZ7500® resist (available from Hoechst Celanese Corporation) and then soft baked on a hot plate at 100°C for 60 seconds . The silicon substrates were exposed with varying doses of i-line energy on a 0.54 Nikon i-line stepper, post exposure baked at 120°C in an oven for 60 seconds and developed in 2.38 wt. percent tetramethyl ammonium hydroxide (TMAH) developer. The exposure energy at which the photoresist was fully developed away was plotted against the resist film thickness. The swing curve from the sinusoidal plot was calculated to be

$$\left(\frac{E_{max} - E_{min}}{2(E_{max} + E_{min})}\right)$$

for a fixed node, where $E_{max}$ and $E_{min}$ are the respective exposure energies at the maximum and minimum of a node. The value of the swing curve was 35.3.

Example 11

Several silicon substrates were spin coated with AZ® 7500 photoresist with film thicknesses ranging from 0.9-1.3µm and soft baked on a hot plate at 100°C for 60 seconds. The solution from Example 8 was coated over the AZ 7500 resist, to give a film thickness of the top coat of 68mm (680 angstroms). The resist was exposed with varying doses of i-line radiation on a 0.54 Nikon i-line stepper. The resist was given a post exposure bake at 120°C for 60 seconds in an oven and developed in 2.38% TMAH developer. The exposure energy at which the photoresist was fully developed away was plotted against the resist film thickness. The swing curve was calculated as described in Example 10, and a value of 9.4 was found.

**Claims**

1. A water-soluble anti-reflective coating composition for a photoresist, the coating having a refractive index of from greater than 1.20 to 1.40, the coating composition comprising a copolymer containing the following units

a)

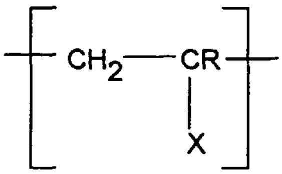

where

X is $CO_2L$, $SO_3L$, OH, $CO(OC_2H_4)_xOH$, $CONHC(CH_3)_2CH_2SO_3L$, $PO_3L_2$ or $CONH_2$, where L is H, a Group I or Group II cation or $NH_4^+$ and x is 0 to 10;

b) an acrylic acid perfluoroalkyl-ester with 8 - 12 C-atoms in the ester alcohol group or

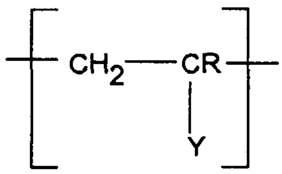

where

Y is fluorine or a fluorine containing aliphatic organic substituent selected from the group consisting of $-COO-(CH_2)_2(CF_2)_{x1}-CF_3$, where x1 is 7 to 11; $-SO_2O(CH_2)_x(CF_2)_n-CF_3$, $-SO_2(OC_2H_4)_xO(CH_2)_x(CF_2)_nCF_3$, where n is 0 - 14 and x is 0-10; and

R is H, halogen, $CF_3$, $(C_1-C_8)$alkyl or CN.

**2.** The anti-reflective coating of claim 1 comprising a copolymer of $CH_2=CH-CO-O-(CH_2)_2(CF_2)x-CF_3$ and acrylic acid, where x = 7 to 11.

**3.** The anti-reflective coating of claim 1 further comprising a surfactant.

**4.** The anti-reflective coating of claim 3, wherein the surfactant comprises ammonium perfluoroctanoate, the amine salt of perfluoroctanoic acid, the tetramethylammonium salt of perfluoroctanoic acid, ammonium perfluoroctanosulfonate, ammonium hydroxide/tetramethylammonium hydroxide or ammonium lauryl sulfate.

**5.** A process for making a water-soluble anti-reflective coating composition for a photoresist, the coating having a refractive index of from greater than 1.20 to 1.40, the process comprising preparing an aqueous solution of the copolymer containing the following units

a)

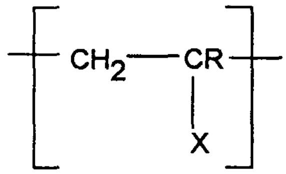

where

X is $CO_2L$, $SO_3L$, OH, $CO(OC_2H_4)_xOH$, $CONHC(CH_3)_2CH_2SO_3L$, $PO_3L_2$ or $CONH_2$, where L is H, a Group I or Group II cation or $NH_4^+$ and x is 0 to 10;

b) an acrylic acid perfluoroalkyl-ester with 8 - 12 C-atoms in the ester alcohol group or

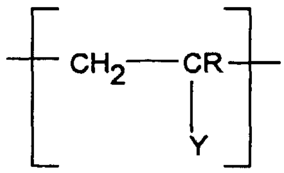

where

Y is fluorine or a fluorine containing aliphatic organic substituent selected from the group consisting of $-COO-(CH_2)_2(CF_2)_{x1}-CF_3$, where x1 is 7 to 11; $-SO_2O(CH_2)_x(CF_2)_n-CF_3$, $-SO_2(OC_2H_4)_xO(CH_2)_x(CF_2)_nCF_3$, where n is 0 - 14 and x is 0 - 10; and

R is H, halogen, $CF_3$, $(C_1-C_8)$alkyl or CN.

**6.** The process of claim 5, wherein the copolymer provided is a copolymer of $CH_2=CH-CO-O-(CH_2)_2(CF_2)x-CF_3$ and acrylic acid, where x =7 to 11.

**7.** The process of claim 5 further comprising adding a surfactant.

**8.** The process of claim 7 wherein the surfactant comprises ammonium perfluoroctanoate, the amine salt of perfluoroctanoic acid, the tetramethylammonium salt of perfluoroctanoic acid, ammonium perfluoroctanosulfonate or ammonium lauryl sulfate.

**Patentansprüche**

**1.** Wasserlösliche, reflexionsvermindernde Zubereitung für eine Photoresistbeschichtung, wobei die

Beschichtung einen Brechungsindex von >1,20 bis 1,40 besitzt und wobei die genannte Zubereitung ein aus folgenden Bestandteilen zusammengesetztes Copolymer enthält:

a)

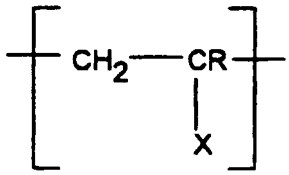

wobei

X $CO_2L$, $SO_3L$, OH, $CO(OC_2H_4)_xOH$, $CONHC(CH_3)_2CH_2SO_3L$, $PO_3L_2$ oder $CONH_2$ ist, wobei L für H, ein Kation der Gruppe I oder der Gruppe II oder $NH_4^+$ steht und wobei x 0 bis 10 ist

b) ein Acrylsäureperfluoralkylester mit 8 bis 12 Kohlenstoffatomen in der Esteralkoholgruppe oder

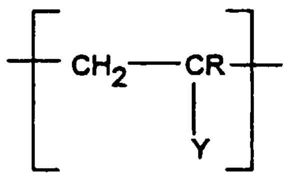

wobei

Y Fluor oder ein unter den folgenden Verbindungen ausgewählter, fluorhaltiger, aliphatischer, organischer Substituent ist: $-COO-(CH_2)_2(CF_2)_{x1}-CF_3$, wobei x1 für 7 bis 11 steht; $-SO_2O(CH_2)_x(CF_2)_n-CF_3$, $-SO_2(OC_2H_4)_xO(CH_2)_x(CF_2)_nCF_3$, wobei n 0 bis 14 und x 0 bis 10 ist; und wobei
R für H, Halogen, $CF_3$, $(C_1-C_8)$-Alkyl oder CN steht.

**2.** Reflexionsvermindernde Beschichtung gemäß Anspruch 1, die ein Copolymer von $CH_2=CH-CO-O-(CH_2)_2(CF_2)_x-CF_3$ und Acrylsäure umfaßt, wobei x 7 bis 11 ist.

**3.** Reflexionsvermindernde Beschichtung gemäß Anspruch 1, die zusätzlich ein Tensid enthält.

**4.** Reflexionsvermindernde Beschichtung gemäß Anspruch 3, wobei das Tensid Ammoniumperfluoroctanoat, das Aminsalz von Perfluoroctansäure, das Tetramethylammoniumsalz von Perfluoroctansäure, Ammoniumperfluoroctansulfonat, Ammoniumhydroxid/ Tetramethylammoniumhydroxid oder Ammoniumlaurylsulfat umfaßt.

**5.** Verfahren zur Herstellung einer wasserlöslichen, reflexionsvermindernden Zubereitung für eine Photoresistbeschichtung, wobei die Beschichtung einen Brechungsindex von >1,20 bis 1,40 besitzt, und wobei das Verfahren die Herstellung einer wäßrigen Lösung eines Copolymers umfaßt, das folgende Bestandteile enthält;

a)

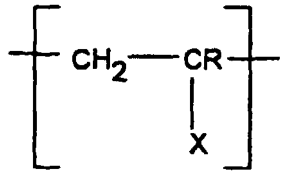

wobei

X $CO_2L$, $SO_3L$, OH, $CO(OC_2H_4)_xOH$, $CONHC(CH_3)_2CH_2SO_3L$, $PO_3L_2$ oder $CONH_2$ ist, wobei L für H, ein Kation der Gruppe I oder der Gruppe II oder $NH_4^+$ steht und wobei x 0 bis 10 ist.

b) ein Acrylsäureperfluoralkylester mit 8 bis 12 Kohlenstoffatomen in der Esteralkoholgruppe oder

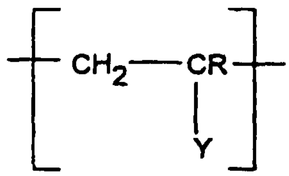

wobei

Y Fluor oder ein unter den folgenden Verbindungen ausgewählter, fluorhaltiger, aliphatischer, organischer Substituent ist: $-COO-(CH_2)_2(CF_2)_{x1}-CF_3$, wobei x1 für 7 bis 11 steht; $-SO_2O(CH_2)_x(CF_2)_n-CF_3$, $-SO_2(OC_2H_4)_xO(CH_2)_x(CF_2)_nCF_3$, wobei n 0 bis 14 und x 0 bis 10 ist; und wobei
R für H, Halogen, $CF_3$, $(C_1-C_8)$-Alkyl oder CN steht.

**6.** Verfahren gemäß Anspruch 5, wobei das Copolymer ein Copolymer von $CH_2$=CH-CO-O-$(CH_2)_2(CF_2)_x$-$CF_3$ und Acrylsäure ist und wobei x 7 bis 11 ist.

**7.** Verfahren gemäß Anspruch 5, wobei zusätzlich ein Tensid zur Anwendung kommt.

**8.** Verfahren gemäß Anspruch 7, wobei das Tensid Ammoniumperfluoroctanoat, das Aminsalz von Perfluoroctansäure, das Tetramethylammoniumsalz von Perfluoroctansäure, Ammoniumperfluoroctansulfonat oder Ammoniumlaurylsulfat umfaßt.

**Revendications**

**1.** Composition hydrosoluble de revêtement anti-réfléchissant pour un photorésist, le revêtement ayant un indice de réfraction supérieur à 1,20 et allant jusqu'à 1,40, la composition de revêtement comprenant un copolymère contenant les motifs suivants

a)

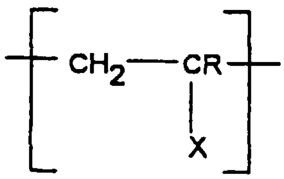

où

X est $CO_2L$, $SO_3L$, OH, $CO(OC_2H_4)_xOH$, $CONHC(CH_3)_2CH_2SO_3L$, $PO_3L_2$ ou $CONH_2$, où L est H, un cation du Groupe I ou du Groupe II ou $NH_4^+$ et x vaut de 0 à 10 ;

b) un ester perfluoroalkylique de l'acide acrylique ayant 8 à 12 atomes de carbone dans le groupe alcool de l'ester ou

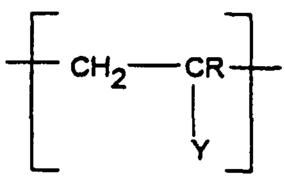

où

y est un atome de fluor ou un substituant organique aliphatique contenant du fluor choisi dans le groupe formé par -COO-$(CH_2)_2(CF_2)_{x1}$-$CF_3$, où x1 vaut de 7 à 11 ; -$SO_2O(CH_2)_x(CF_2)_n$-$CF_3$, -$SO_2(OC_2H_4)_xO(CH_2)_x(CF_2)_nCF_3$, où n vaut de 0 à 14 et x vaut de 0 à 10 ; et

R et un atome de H, d'halogène, un groupe $CF_3$, alkyle (en $C_1$ à $C_8$) ou CN.

**2.** Revêtement anti-réfléchissant selon la revendication 1 comprenant un copolymère de $CH_2$=CH-CO-O-$(CH_2)_2(CF_2)_x$-$CF_3$ et d'acide acrylique, où x = 7 à 11.

**3.** Revêtement anti-réfléchissant selon la revendication 1 comprenant de plus un tensio-actif.

**4.** Revêtement anti-réfléchissant selon la revendication 3, dans lequel le tensio-actif comprend le perfluoro-octanoate d'ammonium, le sel d'amine de l'acide perfluoro-octanoïque, le sel de tétraméthylammonium et de l'acide perfluoro-octanoïque, le perfluoro-octanesulfonate d'ammonium, l'hydroxyde d'ammonium/hydroxyde de tétraméthylammonium ou le laurylsulfate d'ammonium.

**5.** Procédé pour fabriquer une composition hydrosoluble de revêtement anti-réfléchissant pour un photorésist, le revêtement ayant un indice de réfraction supérieur à 1,20 allant jusqu'à 1,40, le procédé consistant à préparer une solution aqueuse du copolymère contenant les motifs suivants

a)

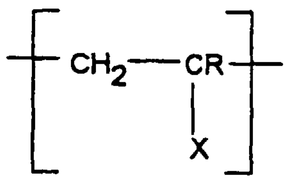

où

X est $CO_2L$, $SO_3L$, OH, $CO(OC_2H_4)_xOH$, $CONHC(CH_3)_2CH_2SO_3L$, $PO_3L_2$ ou $CONH_2$, où L est H, un cation du Groupe I ou du Groupe II ou $NH_4^+$ et x vaut de 0 à 10 ;

b) un ester perfluoroalkylique de l'acide acrylique ayant 8 à 12 atomes de carbone dans le groupe alcool de l'ester ou

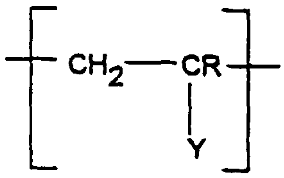

où

Y est un atome de fluor ou un substituant organique aliphatique contenant du fluor choisi dans le groupe formé par -COO-$(CH_2)_2(CF_2)_{x1}$-$CF_3$, où x1 vaut de 7 à 11 ; -$SO_2O(CH_2)_x(CF_2)_n$-$CF_3$, -$SO_2(OC_2H_4)_xO(CH_2)_x(CF_2)_nCF_3$, où n vaut de 0 à 14 et x vaut de 0 à 10 ; et

R est un atome de H, d'halogène, un groupe $CF_3$, alkyle (en $C_1$ à $C_8$) ou CN.

**6.** Procédé selon la revendication 5, dans lequel le copolymère fourni est un copolymère de $CH_2$=CH-CO-O-$(CH_2)_2(CF_2)_x$-$CF_3$ et de l'acide acrylique, où x = 7 à 11.

**7.** Procédé selon la revendication 5 consistant de plus à ajouter un tensio-actif.

**8.** Procédé selon la revendication 7, dans lequel le tensio-actif comprend le perfluoro-octanoate d'ammonium, le sel d'amine de l'acide perfluoro-octanoïque, le sel de tétraméthylammonium et de l'acide perfluoro-octanoïque, le perfluoro-octanesulfonate d'ammonium ou le laurylsulfate d'ammonium.